Europäisches Patentamt

European Patent Office

Office européen des brevets

(11) Numéro de publication: **0 129 477**
A1

(12) **DEMANDE DE BREVET EUROPEEN**

(21) Numéro de dépôt: **84401225.2**

(22) Date de dépôt: **14.06.84**

(51) Int. Cl.³: **H 01 L 29/72**
H 01 L 29/205, H 01 L 27/15

(30) Priorité: **17.06.83 FR 8310073**

(43) Date de publication de la demande:
**27.12.84 Bulletin 84/52**

(84) Etats contractants désignés:
**DE GB NL**

(71) Demandeur: **Ankri, David**
**112 rue Branccou**
**F-75015 Paris(FR)**

(71) Demandeur: **Bouley, Jean-Claude**
**35, Avenue du DR. Durand**
**F-94110 Arcueil(FR)**

(71) Demandeur: **Scavennec, André**
**8 rue Deslandres**
**F-75013 Paris(FR)**

(72) Inventeur: **Ankri, David**
**112 rue Branccou**
**F-75015 Paris(FR)**

(72) Inventeur: **Bouley, Jean-Claude**
**35, Avenue du DR. Durand**
**F-94110 Arcueil(FR)**

(72) Inventeur: **Scavennec, André**
**8 rue Deslandres**
**F-75013 Paris(FR)**

(74) Mandataire: **Mongrédien, André et al,**
**c/o BREVATOME 25, rue de Ponthieu**
**F-75008 Paris(FR)**

(54) **Transistor bipolaire à double hétérojonction compatible avec des composants optoélectroniques pour l'intégration monolithique.**

(57) Transistor bipolaire à double hétérojonction compatible avec des composants optoélectroniques pour l'intégration monolithique.

Il comprend une double hétérostructure par exemple du type n-GaAlAs/n-GaAs/n-GaAlAs. Des impuretés sont implantées dans la couche interne (2) en GaAs, à travers la couche de surface (3) en GaAlAs, de façon à former une zone (6) de type p. D'autres impuretés sont implantées dans la couche de surface, à l'intérieur de ladite zone, de façon à former une zone (7) de type n. Ce procédé de fabrication par double implantation ionique est également compatible avec les procédés de réalisation des composants optoélectroniques tels que lasers, phototransistors.

Application aux télécommunications optiques.

FIG.1

EP 0 129 477 A1

<u>Transistor bipolaire à double hétérojonction compatible avec des composants optoélectroniques pour l'intégration monolithique.</u>

La présente invention concerne un transistor bipolaire à double hétérojonction compatible avec des composants optoélectroniques pour l'intégration monolithique. Elle trouve notamment une application dans le domaine des télécommunications optiques.

On sait que dans ce domaine se pose le problème de l'intégration monolithique de composants optoélectroniques et microélectroniques, en ce qui concerne la réalisation de répéteurs par exemple.

L'intégration monolithique d'émetteurs ou de récepteurs de lumière et de circuits électroniques de polarisation, de commande, de multiplexage et de démultiplexage a été rapportée dans un article de R.KOLBAS et al. publié dans SPIE, vol.321, Integrated Optics II (1982), pages 94 à 102. Les circuits électroniques considérés sont réalisés à partir de transistors à effet de champ au GaAs, à grilles formant une barrière de SCHOTTKY, connus sous le nom de MESFET au GaAs, ce qui présente l'inconvénient de conduire à un procédé d'intégration compliqué. En effet, au cours de cette intégration, les émetteurs et les récepteurs de lumière sont réalisés en utilisant une épitaxie dans un puits pour obtenir la structure multi-couche épitaxiée la plus adaptée aux émetteurs et aux récepteurs, et la surface la plus adaptée aux transistors MESFET est rétablie par gravure ou par épitaxie sélective. En outre, les procédés de fabrication des transistors MESFET et des émetteurs ou des récepteurs de lumière sont différents.

La présente invention a pour objet un transistor bipolaire à double hétérojonction permettant l'intégration monolithique de celui-ci et de composants optoélectroniques sans les inconvénients précédents, notamment en ce que ledit transistor est réa-

B 7831.C PV

lisé à partir d'une structure compatible avec la structure à partir de laquelle sont réalisés des composants optoélectroniques tels que les lasers (en particulier les lasers à jonction transverse connus sous le nom de lasers TJS et les lasers à ruban implanté), les diodes PIN et les phototransistors bipolaires, et suivant un procédé également compatible avec les procédés de réalisation desdits composants.

De façon précise, la présente invention a pour objet un transistor bipolaire à double hétérojonction, caractérisé en ce qu'il comprend :

- une double hétérostructure comportant une couche interne semiconductrice réalisée au moyen d'un matériau semiconducteur et encadrée par une première et une seconde couches externes semiconductrices, chaque couche externe étant réalisée en un matériau semiconducteur présentant une largeur de bande interdite supérieure à celle du matériau semiconducteur avec lequel est réalisée la couche interne, la seconde couche externe ayant un type de dopage donné,
- une première zone définie par des premières impuretés implantées dans la couche interne à travers la première couche externe et prévues pour donner à la première zone un dopage de type opposé audit type donné, de manière à former une hétérojonction entre la première zone et la seconde couche externe, et
- une seconde zone définie par des secondes impuretés implantées dans la première couche externe, à l'intérieur de la première zone, et prévues pour donner à la seconde zone un dopage de type identique audit type donné, de manière à former une autre hétérojonction entre la première et la seconde zones.

Les couches externes peuvent être réalisées avec un même matériau semiconducteur ou avec deux matériaux semiconducteurs différents, ce ou ces maté-

B 7831.C PV

riaux ayant une largeur de bande interdite supérieure
à celle du matériau constituant la couche interne.

Selon un mode de réalisation préféré du
transistor objet de l'invention, les couches externes
sont en GaAlAs de type n et la couche interne est en
GaAs de type n.

Selon un mode de réalisation particulier du
transistor objet de l'invention, la couche interne est
en un matériau composé III-V et        chaque couche externe est en un autre matériau composé III-V
présentant une largeur de bande interdite supérieure à
celle dudit matériau composé III-V, ces matériaux composés III-V étant non dopés intentionnellement ou de
même type de dopage, n de préférence.

Selon un autre mode de réalisation particulier, le transistor comprend en outre un substrat
semi-isolant et une couche tampon semiconductrice intercalée entre le substrat et la seconde couche externe et fortement dopée avec le même type de dopage que
cette dernière.

Enfin, selon un autre mode de réalisation
particulier, la double hétérostructure est munie d'une
couche de contact semiconductrice disposée contre la
première couche externe, les première et seconde zones
s'étendent à travers cette couche de contact et la
jonction latérale entre la première et la seconde zones est éliminée sur toute l'épaisseur de ladite couche de contact.

La présente invention sera mieux comprise à
la lecture de la description qui suit, d'exemples de
réalisation donnés à titre indicatif et nullement limitatif, en référence aux dessins annexés sur lesquels :

- les figures 1 à 3 sont des vues schématiques de modes de réalisation particuliers du transistor objet de l'invention, et

- la figure 4 est vue schématique de l'intégration monolithique d'un transistor selon l'invention, d'un phototransistor bipolaire et d'un laser à jonction transverse.

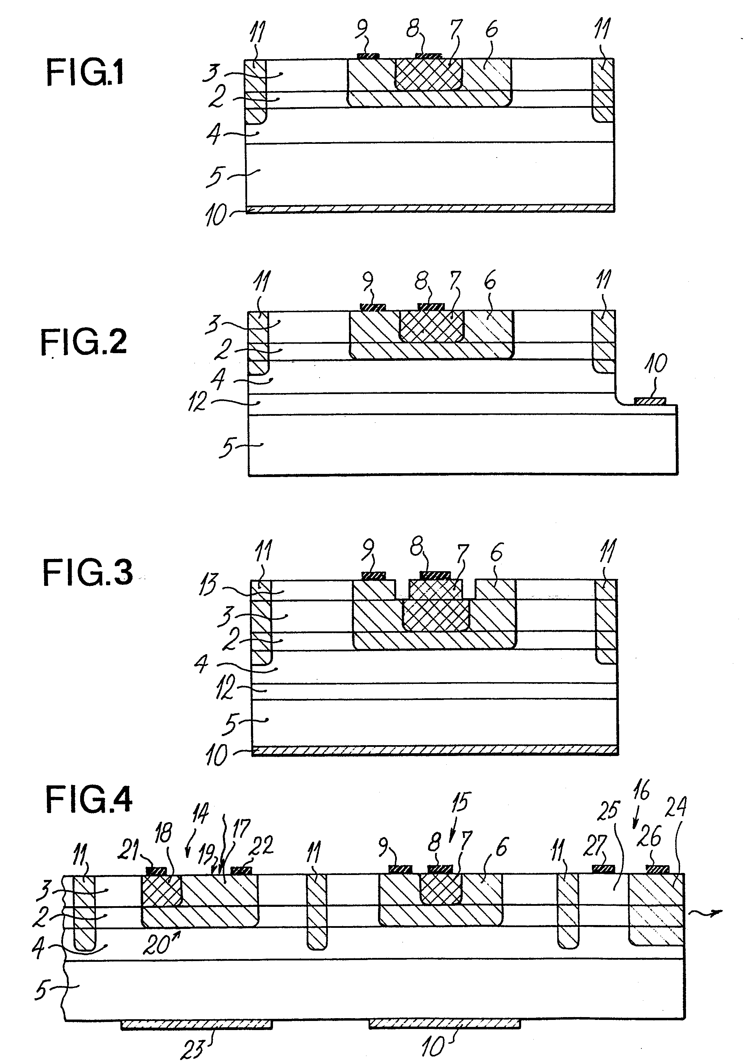

Sur la figure 1, on a représenté schématiquement un mode de réalisation particulier du transistor bipolaire à double hétérojonction objet de l'invention. Il comprend une double hétérostructure constituée par une couche interne 2, ou couche active, en n-GaAs, encadrée par une première couche externe 3 et une seconde couche externe 4, encore appelées couches de confinement, en n-GaAlAs. Cette double hétérostructure est formée sur un substrat 5 par exemple en GaAs fortement dopé de type $n^+$, la seconde couche externe 4 étant formée sur le substrat 5.

Le transistor comprend également une première zone 6 de type p, s'étendant jusque dans la couche active 2, à partir de la surface de la première couche de confinement 3 et à travers celle-ci, ainsi qu'une seconde zone 7 de type n, contenue à l'intérieur de la première zone 6 et s'étendant dans la première couche de confinement 3, à partir de la surface de celle-ci.

La première zone 6, la seconde zone 7 et la seconde couche de confinement 4 constituent respectivement la base, l'émetteur et le collecteur du transistor.

Ce transistor est réalisé de la façon suivante : on commence par déposer successivement sur le substrat la seconde couche de confinement 4, la couche active 2 et la première couche de confinement 3, par épitaxie en phase liquide ou par épitaxie en phase vapeur (par exemple par épitaxie par jets moléculaires ou par épitaxie par décomposition d'organo-métalliques). On implante ensuite dans la couche active 2, à travers la première couche de confinement 3, des impu-

B 7831.C PV

retés de type p, par exemple des ions Be, de manière à former la première zone 6. On implante ensuite dans la première couche de confinement 3, à l'intérieur de la première zone 6, d'autres impuretés de type n, par exemple constituées par des ions Si ou Se, de manière à former la seconde zone 7. Après chaque implantation, on effectue par un procédé connu, un recuit d'implantation (avec ou sans encapsulant).

On procède ensuite au dépôt des métallisations du contact d'émetteur 8 à la surface de la seconde zone 7, du contact de base 9 à la surface de la première zone 6, bien entendu en dehors de la seconde zone 7, et du contact de collecteur 10 au-dessous du substrat 5. On effectue enfin l'isolation électrique du transistor par création de zones isolantes 11 s'étendant jusque dans la seconde couche de confinement 4, à l'aide d'une implantation ionique de bore et/ou de protons par exemple.

La réalisation de certaines fonctions logiques peut être facilitée en utilisant la seconde zone 7 et la seconde couche de confinement 4 respectivement en tant que collecteur et émetteur du transistor.

A titre indicatif et non limitatif, le substrat 5 a une épaisseur de l'ordre de 15 à 25 $\mu m$, la première couche de confinement 3 a une épaisseur de l'ordre de 2 $\mu m$, un dopage de type n de l'ordre de $5.10^{16}$ $cm^{-3}$ est une concentration x en aluminium de l'ordre de 30 à 35%, la couche active a une épaisseur de l'ordre de 0,3 à 0,5 $\mu m$ et un dopage de type n de l'ordre de $10^{18}$ $cm^{-3}$, la seconde couche de confinement 4 a une épaisseur de l'ordre de 3 à 5 $\mu m$, un dopage de type n de l'ordre de $5.10^{16} cm^{-3}$ et une concentration x en aluminium de l'ordre de 30 à 35%, la concentration x étant définie en écrivant GaAlAs sous la forme $Ga_{1-x}Al_xAs$.

Dans un autre mode de réalisation particulier schématiquement représenté sur la figure 2, le transistor selon l'invention comprend une couche tampon 12, par exemple en $n^+$-GaAs, intercalée entre la seconde couche de confinement 4 et le substrat 5, celui-ci étant alors semi-isolant.

Ce substrat permet de disposer le contact de collecteur 10 sur la même face que les autres contacts, ledit contact 10 étant alors réalisé sur la couche tampon en $n^+$-GaAs, ce qui facilite l'intégration du transistor.

Dans un autre mode de réalisation particulier schématiquement représenté sur la figure 3, le transistor objet de l'invention peut également comprendre, outre la couche tampon 12, une couche de contact 13, par exemple en n-GaAs, déposée sur la première couche de confinement après que celle-ci ait été déposée lors de la réalisation de la double hétérostructure. Dans ce cas, la première zone 6 est réalisée par implantation ionique dans la couche active 2, à travers la couche de contact 13 et la première couche de confinement 3, et la seconde zone 7 est réalisée par implantation ionique, à l'intérieur de la première zone 6, dans la première couche de confinement 3, à travers la couche de contact 13. Après avoir réalisé les zones 6 et 7 qui sont respectivement de type p et n, on élimine la jonction latérale entre ces zones sur toute l'épaisseur de la couche de contact 13, en décapant localement celle-ci jusqu'à la première couche de confinement 3, de façon à isoler les zones 6 et 7 l'une de l'autre.

Dans le domaine des télécommunications optiques, on a besoin de réaliser des systèmes comportant un émetteur de lumière tel qu'un laser, associé à un circuit de commande, un circuit de modulation et un circuit logique de traitement de l'information que le laser doit émettre sous forme lumineuse. De tel circuits peuvent être réalisés à l'aide de transistors bipolaires à double hétérojonction selon l'invention. Notamment dans le cas de la fabrication de répéteurs, on est amené à associer au laser et aux circuits précédents un récepteur de lumière tel qu'un photo-transistor ou une photo-diode réceptrice du type PIN par exemple.

Le transistor objet de l'invention présente justement l'avantage de pouvoir être intégré de façon monolithique avec un laser tel qu'un laser à jonction transverse ou un laser à ruban implanté, et avec une diode PIN ou un photo-transistor tel qu'un photo-transistor à hétérojonction émetteur-base à couche d'émetteur localement de type inversé, car tous ces composants ont des structures compatibles. Ils peuvent en effet être réalisés à partir d'une même double hétérostructure et suivant des procédés comparables. Les lasers à jonction transverse sont d'ailleurs tout à fait adaptés à l'intégration avec le transistor objet de l'invention car ils sont capables d'émettre des informations à un débit élevé (jusqu'à 8 gigabits/s voire plus) et sont donc compatibles avec des circuits logiques très rapides du genre de ceux qui sont constitués à partir de transistors bipolaires à double hétérojonction selon l'invention.

Sur la figure 4, on a illustré l'intérêt que présente l'invention, en représentant schématiquement un exemple d'intégration monolithique d'un photo-transistor 14 à hétérojonction émetteur-base à couche d'émetteur localement de type inversé, d'un transistor bipolaire 15 à double hétérojonction selon l'invention et d'un laser 16 à jonction transverse.

Ces trois composants sont réalisés dans une

B 7831.C PV

0129477

même hétérostructure obtenue en déposant successivement par épitaxie sur un substrat 5 par exemple en $n^+$-GaAs, une couche de confinement 4 en n-GaAlAs, une couche active 2 en n-GaAs et une couche de confinement 3 en n-GaAlAs. Le transistor bipolaire à double hétérojonction selon l'invention est constitué et réalisé (à l'aide d'une double implantation ionique) comme on l'a expliqué précédemment. Le photo-transistor 14 peut être réalisé à l'aide d'une première implantation d'impuretés de type p dans la couche active 2, à travers la première couche de confinement 3, de manière à former une première zone 17 de type p, puis à l'aide d'une seconde implantation d'autres impuretés de type n dans la première couche de confinement 3, à l'intérieur de la première zone 17, de manière à former une seconde zone 18 de type n, la seconde implantation étant réalisée de manière que la seconde zone 18 se trouve sur un bord de la première zone 17. La seconde zone 18 correspond à la zone d'émetteur du phototransistor ; la portion 19 de la première zone 17, située dans la première couche de confinement 3, correspond à la zone de type inversé de la couche d'émetteur ; et la portion 20 de la première zone 17, située dans la couche active 2, correspond à la base du photo-transistor, la seconde couche de confinement 4 correspondant au collecteur dudit phototransistor. On a également représenté le contact d'émetteur 21, le contact de base 22 et le contact collecteur 23. Les contacts de collecteur 10 et 23 appartenant respectivement au transistor 15 et au phototransistor 14 sont réalisés sur le substrat 5 en $n^+$-GaAs.

On pourrait bien entendu intercaler une couche tampon, par exemple en $n^+$-GaAs, entre la couche de confinement 4 et le substrat 5, ce dernier étant alors semi-isolant, et réaliser les contacts 10 et 23 sur la couche tampon, comme on l'a expliqué dans la description de la figure 2.

Le laser à jonction transverse 16 peut être obtenu par implantation d'impuretés de type p dans la seconde couche de confinement 4, à travers la première couche de confinement 3 et la couche active 2, de manière à constituer une zone 24 de type $p^+$, constituant l'anode du laser. La cathode de celui-ci est constituée par la partie 25 de la première couche de confinement 3 adjacente à la zone 24. On a également représenté le contact d'anode 26 et le contact de cathode 27. On voit également sur la figure 4 des zones isolantes 11 séparant les composants 14, 15, 16 les uns des autres.

Dans ce qui précède, on a considéré un transistor selon l'invention, réalisé dans une double hétérostructure du type n-GaAlAs/n-GaAs/n-GaAlAs. On pourrait bien entendu réaliser le transistor selon l'invention dans une double hétérostructure comprenant une couche active en p-GaAs intercalée entre une première couche de confinement en p-GaAlAs et une seconde couche de confinement en p-GaAlAs et en réalisant, par implantation ionique, une première zone de type n dans la couche active, à travers la première couche de confinement, puis une seconde zone de type p à l'intérieur de la première zone, dans la première couche de confinement. Dans ce cas, le laser à jonction transverse décrit en référence à la figure 4, serait formé en réalisant par implantation ionique une zone 24 de type n.

Par ailleurs, on pourrait utiliser d'autres matériaux composés III-V pour réaliser la double hétérostructure, en intercalant une couche d'un matériau composé III-V présentant une bande interdite de faible largeur entre deux couches d'un autre matériau composé

B 7831.C PV

III-V présentant une bande interdite de grande largeur. En particulier, on pourrait utiliser, à titre indicatif et non limitatif, une couche de GaInAsP intercalée entre deux couches de InP, ou bien une couche de GaInAs intercalée entre deux couches de InP, ou encore une couche de GaInAs intercalée entre deux couches de AlInAs.

REVENDICATIONS

1. Transistor bipolaire à double hétérojonction, caractérisé en ce qu'il comprend :

- une double hétérostructure comportant une couche interne semiconductrice (2) réalisée au moyen d'un matériau semiconducteur et encadrée par une première et une seconde couches externes semiconductrices (3, 4), chaque couche externe étant réalisée en un matériau semiconducteur présentant une largeur de bande interdite supérieure à celle du matériau semiconducteur avec lequel est réalisée la couche interne, la seconde couche externe ayant un type de dopage donné,

- une première zone (6) définie par des premières impuretés implantées dans la couche interne (2) à travers la première couche externe (3) et prévues pour donner à la première zone un dopage de type opposé audit type donné, de manière à former une hétérojonction entre la première zone et la seconde couche externe, et

- une seconde zone (7) définie par des secondes impuretés implantées dans la première couche externe (3), à l'intérieur de la première zone (6), et prévues pour donner à la seconde zone un dopage de type identique audit type donné, de manière à former une autre hétérojonction entre la première et la seconde zones.

2. Transistor selon la revendication 1, caractérisé en ce que les couches externes (3, 4) sont en GaAlAs de type n et en ce que la couche interne (2) est en GaAs de type n.

3. Transistor selon la revendication 1, caractérisé en ce que la couche interne (2) est en un matériau composé III-V et en ce que chaque couche ex-

B 7831.C PV

terne (3, 4) est en un autre matériau composé III-V présentant une largeur de bande interdite supérieure à celle dudit matériau composé III-V, ces matériaux composés III-V étant non dopés intentionnellement ou de même type de dopage.

4. Transistor selon l'une quelconque des revendications 1 à 3, caractérisé en ce qu'il comprend en outre un substrat semi-isolant (5) et une couche tampon semiconductrice (12) intercalée entre le substrat et la seconde couche externe (4) et fortement dopée avec le même type de dopage que cette dernière.

5. Transistor selon l'une quelconque des revendications 1 à 4, caractérisé en ce que la double hétérostructure est munie d'une couche de contact semiconductrice (13) disposée contre la première couche externe (3), en ce que les première et seconde zones (6, 7) s'étendent à travers cette couche de contact et en ce que la jonction latérale entre la première et la seconde zones est éliminée sur toute l'épaisseur de ladite couche de contact.

B 7831.C PV

FIG.1

FIG.2

FIG.3

FIG.4

**0129477**
Numéro de la demande

Office européen
des brevets

# RAPPORT DE RECHERCHE EUROPEENNE

EP 84 40 1225

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | IEEE ELECTRON DEVICES LETTERS, volume EDL-4, no. 5, mai 1983 (NEW YORK, US) S.L. SU et al.: "Double heterojunction AlxGal-xAs/GaAs bipolar transistors (DHBJT's) by MBE with a current gain of 1650", pages 130-132 <br> * page 131; figure 1 * | 1-5 | H 01 L 29/72 <br> H 01 L 29/205 <br> H 01 L 27/15 |
| A | US-A-4 160 258 (L.R. DAWSON) <br> * abrégé; figures 1-3 * | 1-5 | |
| A | US-A-4 352 116 (A. YARIV) | | |

| | DOMAINES TECHNIQUES RECHERCHES (Int. Cl. ³) |
|---|---|
| | H 01 L |

Le présent rapport de recherche a été établi pour toutes les revendications

| Lieu de la recherche | Date d'achèvement de la recherche | Examinateur |
|---|---|---|
| LA HAYE | 24-09-1984 | PELSERS L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82